## Europäisches Patentamt
## European Patent Office
## Office européen des brevets

(19)

(11) Veröffentlichungsnummer: **0 285 896 B1**

(12) **EUROPÄISCHE PATENTSCHRIFT**

(45) Veröffentlichungstag der Patentschrift: **03.08.94**

(51) Int. Cl.⁵: **G01R 31/305**

(21) Anmeldenummer: **88104509.0**

(22) Anmeldetag: **21.03.88**

(54) **Verfahren zum Testen von Leitungsnetzwerken.**

(30) Priorität: **10.04.87 DE 3712176**

(43) Veröffentlichungstag der Anmeldung:
**12.10.88 Patentblatt 88/41**

(45) Bekanntmachung des Hinweises auf die
Patenterteilung:
**03.08.94 Patentblatt 94/31**

(84) Benannte Vertragsstaaten:
**AT BE CH DE ES FR GB IT LI NL**

(56) Entgegenhaltungen:
**EP-A- 0 066 070**
**EP-A- 0 166 912**
**EP-A- 0 189 777**

**Scanning electron microscopy 1985, Chicago,USA Seiten 991 - 999; M.Brunner et.al.: "A dynamic single E-beam short/open testing technique"**

(73) Patentinhaber: **SIEMENS AKTIENGESELL-SCHAFT**
**Wittelsbacherplatz 2**
**D-80333 München(DE)**

(72) Erfinder: **Brunner, Matthias, Dr.**
**Graf-Andechs-Strasse 30**
**D-8011 Kirchheim(DE)**

## Beschreibung

Die Erfindung betrifft ein Verfahren zum Testen von Leitungsnetzwerken nach dem Oberbegriff des Patentanspruchs 1.

Ein solches Verfahren ist aus der Veröffentlichung von M. Brunner "A dynamic single e-beam short/open testing technique" Scanning Electron Microscopy /1985/III, Seite 991-999 bekannt. Zur Aufladung des Leitungsnetzwerkes und zum Abtasten der sich entsprechend der Netzwerkgeometrie und der vorhandenen Kurzschlüsse bzw. Unterbrechungen an den Kontaktpunkten aufbauenden Potentiale, verwendet man einen Elektronenstrahl, dessen Primärenergie während der Messung konstant gehalten wird.

Ein Verfahren zum berührungslosen Testen von Verdrahtungsmoduln auf Kurzschlüsse und Unterbrechungen unter Verwendung mehrerer Elektronenstrahlen ist aus der amerikanischen Patentschrift 4 417 203 bekannt.

Die genannten Verfahren sind allerdings nur dann fehlerfrei anwendbar, wenn die durch einen Elektronenstrahl aufgebrachte Ladung während des gesamten Meßvorgangs im Netzwerk gespeichert bleibt. Da nicht alle Leiterplatten und Verdrahtungsmodule ausreichend hohe Isolationswiderstände von mehr als etwa $10^{12}$ Ohm aufweisen, können Teile des Netzwerkes durch Kriechströme soweit entladen werden, daß ein in diesen Bereichen gemessenes Sekundärelektronensignal eine tatsächlich nicht vorhandene Unterbrechung vortäuscht.

Der Erfindung liegt die Aufgabe zugrunde, ein Verfahren der eingangs genannten Art anzugeben, bei dem jeder Entladevorgang kompensiert wird. Es soll insbesondere gewährleistet sein, daß das durch einen Ladestrahl erzeugte Potential auf einem höheren Niveau stabilisiert wird. Diese Aufgabe wird erfindungsgemäß durch ein Verfahren nach Patentanspruch 1 gelöst.

Der mit der Erfindung erzielbare Vorteil besteht insbesondere darin, daß auch Leiterplatten und Verdrahtungsmodule mit niedrigen Isolationswiderständen fehlerfrei auf Kurzschlüsse und Unterbrechungen überprüft werden können.

Die Ansprüche 2 bis 6 sind auf bevorzugte Ausgestaltungen und Weiterbildungen der Erfindung gerichtet.

Das erfindungsgemäße Verfahren wird nachfolgend anhand der Zeichnungen erläutert. Hierbei zeigt:

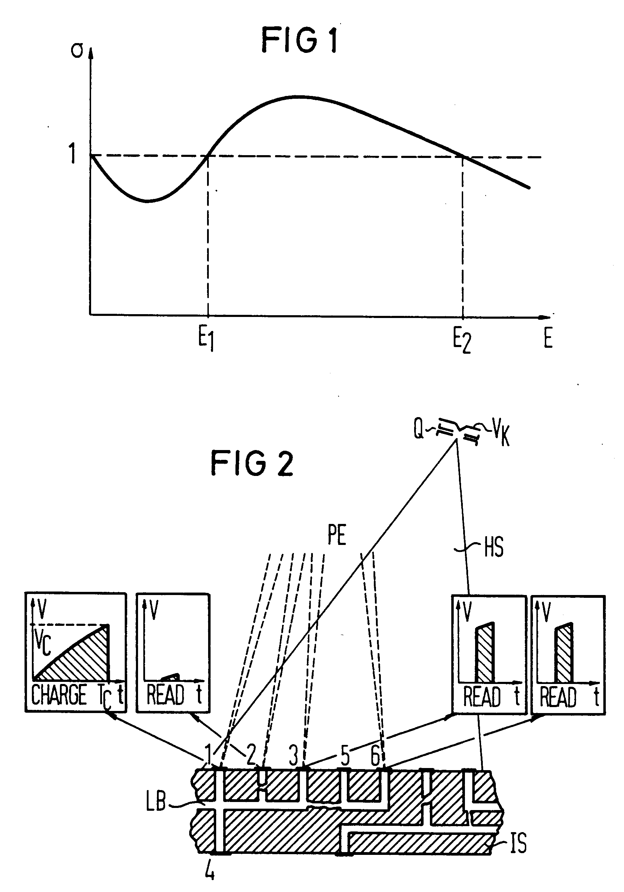

FIG 1 die Energieabhängigkeit der Ausbeute emittierter Elektronen,

FIG 2 eine Leiterplatte mit mehreren Netzwerken Durch geeignete Wahl der Energie eines auf die Oberfläche einer nichtleitenden Probe gerichteten Elektronenstrahls kann man erreichen, daß der auf die Probe auftreffende Strom der Primärteilchen nicht durch den von ihr ausgehenden Strom der rückgestreuten und sekundären Teilchen kompensiert wird. Entscheidend für den Aufladevorgang ist hierbei die üblicherweise als Ausbeute emittierter Elektronen $\sigma$ bezeichnete mittlere Zahl der pro einfallendem Primärelektron ausgelösten rückgestreuten und sekundären Elektronen (im folgenden kurz Elektronenausbeute genannt) deren Energieabhängigkeit schematisch in FIG 1 dargestellt ist. Die Elektronenausbeute $\sigma$ steigt nach Durchlaufen eines Minimums mit der Elektronenenergie E an, erreicht üblicherweise ein Maximum und fällt bei höheren Energien E langsam wieder ab. Im allgemeinen existieren zwei in FIG 1 mit $E_1$ und $E_2$ bezeichnete Energiewerte für die $\sigma\,(E_1) = \sigma\,(E_2) = 1$ wird. Ein auf diese Energien beschleunigter Elektronenstrahl ändert den Ladungszustand der Probe nicht, da ein auftreffendes Primärelektron im Mittel jeweils gerade ein Elektron auslöst. Man bezeichnet $E_1$ bzw. $E_2$ deshalb auch als Neutralpunktenergien, wobei $E_1$ typischerweise im Energiebereich unterhalb etwa 0.5 keV und $E_2$ mit wenigen Ausnahmen im Energiebereich zwischen etwa 0.5 und 4 keV liegt. Bestrahlt man die Probe mit Elektronen, deren Energie nicht mit einer der Neutralpunktenergien $E_1$ bzw. $E_2$ übereinstimmt, so laden sich nichtleitende Probenbereiche allmählich positiv ($E_1 < E_{PE} < E_2, \sigma > 1$) oder negativ ($E_{PE} > E_2$, $E_{PE} < E_1, \sigma < 1$) auf, bis sich ein Gleichgewichtszustand einstellt. Dieser Gleichgewichtszustand ist für Primärelektronen der Energie $E_{PE} > E_2$ erreicht, wenn diese in dem sich oberhalb der Probe aufbauenden elektrischen Feld soweit abgebremst werden, daß deren Auftreffenergie gerade mit der für das jeweilige Oberflächenmaterial charakteristischen Neutralpunktenergie $E_2$ übereinstimmt. Elektronen der Energie $E_1 < E_{PE} < E_2$ vermögen die Probe allerdings nur bis auf wenige Volt positiv aufzuladen, da die kinetische Energie der emittierten Sekundärelektronen dann nicht mehr ausreicht die Probe zu verlassen. Zur Erzeugung hoher positiver Potentiale müssen die Sekundärelektronen mit Hilfe einer Elektrode von der Probe abgesaugt werden.

Durch geeignete Wahl der Energie des Ladestrahls lassen sich somit Potentiale jeden Vorzeichens auf einer Probe, insbesondere einem Leitungsnetzwerk erzeugen. Da die Energieverteilung der emittierten Sekundärelektronen durch vorhandene Probenpotentiale beeinflußt wird, kann man auch den Ladungszustand bzw. das Potential am Auslösepunkt der Sekundärelektronen sowohl qualitativ als auch quantitativ mit Hilfe eines auf dem interessierenden Meßpunkt positionierten Elektronenstrahls bestimmen. Meßgröße ist hierbei jeweils der in einem oberhalb der Probe angeordneten Detektor registrierte Sekundärelektronenstrom.

Die FIG 2 zeigt im Ausschnitt mehrere Netzwerke einer Leiterplatte. Hierbei sollen die an der Oberfläche einer Isolationsschicht IS angeordneten Kontaktpunkte 1 bis 4 und die diese Punkte verbindenden Leiterbahnen LB entsprechend der gewünschten elektrischen Funktion ein Netzwerk A und die Kontaktpunkte 5 und 6 mit den zugeordneten Leiterbahnen LB ein gegenüber Netzwerk A isoliert liegendes Netzwerk B bilden. Entsprechendes gilt für die anderen nicht näher bezeichneten Kontaktpunkte in FIG 2. Ohne Einschränkung kann angenommen werden, daß die Leiterplatte vor Beginn der Messung nicht geladen ist.

Zur Überprüfung der Leiterplatte auf Kurzschlüsse und Unterbrechungen wird zunächst ein Kontaktpunkt, beispielsweise Kontaktpunkt 1 des Netzwerkes A, mit Hilfe eines in der elektronenoptischen Säule eines modifizierten Rasterelektronenmikroskopes erzeugten Elektronenstrahls PE innerhalb einer von der Kapazität des Netzwerkes abhängigen Zeit $T_C$ auf ein Potential $V_C$ aufgeladen. Die Zeitabhängigkeit des Kontaktpunktpotentials $V_C$ ist in dem oberen linken Teil der FIG 2 in Form eines Diagrammes dargestellt. Ist das gewünschte Aufladepotential $V_C$ erreicht, wird der Elektronenstrahl PE ausgetastet und mit unveränderter Primärenergie auf einem anderen Kontaktpunkt des Netzwerkes A positioniert, um dessen Potential durch Nachweis der dort ausgelösten Sekundärelektronen abzutasten. Registriert man innerhalb der Meßzeit den gleichen Sekundärelektronenstrom, also das gleiche Potential $V_C$ wie am Aufladepunkt 1, so sind beide Punkte leitend miteinander verbunden. Diese Bedingung ist für den Kontaktpunkt 3 erfüllt (siehe Diagramm im oberen rechten Teil der FIG 2). Im Unterschied hierzu bleibt der Kontaktpunkt 2 aufgrund einer Unterbrechung ungeladen, so daß man hier nur einen kleineren Sekundärelektronenstrom im Detektor registriert. Wie im rechten Diagramm der FIG 2 dargestellt, wird auch beim Abtasten des Kontaktpunktes 6 innerhalb der Meßgenauigkeit das gleiche Potential wie am Aufladepunkt 1 gemessen. Damit sind beide Punkte notwendigerweise leitend miteinander verbunden und ein nicht erwünschter Kurzschluß der Netzwerke A und B ist nachgewiesen.

Um Kurzschlüsse und Unterbrechungen durch Messung der an den einzelnen Kontaktpunkten vorhandenen Potentiale sicher nachzuweisen, muß die in die Netzwerke A und B eingebrachte Ladung während der gesamten Meßzeit gespeichert bleiben. Zur Kompensation der beispielsweise durch Kriechströme verursachten Ladungsverluste wird deshalb erfindungsgemäß vorgeschlagen, die Leiterplatte während der Messung zumindest in den mit dem Elektronenstrahl PE abzutastenden Bereichen mit einem diese Bereiche überdeckenden Haltestrahl HS zu beaufschlagen. Dieser Haltestrahl HS kann beispielsweise mit Hilfe einer aus Kathode, Wehnelt-Elektrode und Anode bestehenden Elektronenquelle Q erzeugt werden, die man vorteilhafterweise seitlich oberhalb der zu überprüfenden Leiterplatte in der Probenkammer des den Lade- und/oder Lesestrahl PE erzeugenden Rasterelektronenmikroskops anordnet. Die Energie der Elektronen des Haltestrahls HS kann man hierbei mit Hilfe des variablen Anodenpotentials so einstellen, daß die in den Leitungsnetzwerken durch Kriechströme verursachten Ladungsverluste automatisch kompensiert werden. Da die Energie $E_{PE}$ des Lade- bzw. Lesestrahls (bei dem Verfahren nach Brunner sind Lade- und Lesestrahl identisch, bei dem in der amerikanischen Patentschrift 4 417 203 beschriebenen Verfahren werden verschiedene Strahlen zum Erzeugen und Abtasten der Potentiale verwendet) die Energie $E_{HS}$ der Haltestrahlelektronen bestimmt, sind zwei im folgenden mit a) und b) bezeichnete Betriebsarten zu unterscheiden.

Betriebsart a) $E_{PE} > E_2$ oder $E_{PE} < E_1$ , $E_{HS} > E_1$ wobei im Falle $E_{PE} > E_2$ die Bedingung $E_{PE}- E_2 > E_{HS} - E_1$ und im Falle $E_{PE} < E_1$ die Bedingung $E_1 - E_{PE} > E_{HS} - E_1$ erfüllt sein muß.

Der Haltestrahl HS der Energie $E_{HS}>E_1$ (z. B. $E_{HS} - E_1$ = 50 eV) stabilisiert sowohl den Isolator IS als auch die Kontaktpunkte 1 bis 6 der Netzwerke A und B auf einem durch das oberhalb der Leiterplatte beispielsweise mit Hilfe einer Elektrode des Sekundärelektronendetektors aufgebaute Absaugfeld definierten positiven Potential, oder, falls man die Sekundärelektronen nicht absaugt, auf Masse. Da der Ladestrahl PE der Energie $E_{PE} > E_2$ bzw. $E_{PE} < E_1$ den Kontaktpunkt 1 des Netzwerkes A und alle mit diesem in leitender Verbindung stehenden Punkte 3 bis 6 auf das Potential $V_C$ ($eV_C$ = $E_{PE} - E_2$ für $E_{PE} > E_2$ bzw. $eV_C = E_{PE}$ für $E_{PE} < E_1$) negativ auflädt, werden die Elektronen des Haltestrahls HS an diesen Punkten soweit abgebremst, daß sie diese mit einer Endenergie $E_{HS} - eV_C < E_1$ erreichen. Die Aus beute emittierter Elektronen $\sigma$ wird dadurch kleiner als 1 und die Kontaktpunkte laden sich bis auf das Potential $V_K$ der Kathode der Haltestrahlquelle Q negativ auf ($V_K \approx$ - 100 bis - 150 V), wobei der Haltestrom jeden durch Kriechströme verursachten Ladungsverlust automatisch ausgleicht. Zur ganzflächigen Entladung der Leiterplatte erhöht man die Energie $E_{HS}$ der Haltestrahlelektronen kurzzeitig soweit, daß die Elektronenausbeute $\sigma$ auch an negativ geladenen Kontaktpunkten größer als 1 ist.

Betriebsart b) $E_1 < E_{PE} < E_2$, $E_{HS} < E_1$
Der Haltestrahl HS der Energie $E_{HS} < E_1$ (z. B. $E_1 - E_{HS}$ = 50 eV) stabilisiert sowohl den Isolator IS als auch die Kontaktpunkte 1 bis 6 der Netzwerke A und B auf dem Potential $V_K$ der Kathode der Haltestrahlquelle Q, also beispielsweise auf - 100 bis - 150 Volt. Da der Ladestrahl PE der Energie $E_1 <$

$E_{PE} < E_2$ den Kontaktpunkt 1 und alle mit diesem leitend verbundenen Kontaktpunkte 3 bis 6 auf ein durch das oberhalb der Leiterplatte aufgebaute Absaugfeld definiertes positives Potential auflädt, werden die Elektronen des Haltestrahls HS im Bereich dieser Punkte beschleunigt, so daß sie diese mit einer Endenergie $E_{HS} + eV_C$ ($V_C$ bezeichnet das durch den Ladestrahl erzeugte Potential) erreichen. Das Absaugfeld muß hierbei so dimensioniert sein, daß die Bedingung $E_{HS} + eV_C > E_1$ erfüllt wird. Die Elektronenausbeute $\sigma$ wird damit größer als 1 und die Kontaktpunkte bleiben positiv geladen, wobei der Haltestrom jeden Ladungsverlust automatisch kompensiert. Zur großflächigen Entladung der Leiterplatte reduziert man die Energie $E_{HS}$ der Haltestrahlelektronen kurzzeitig soweit, bis die Elektronenausbeute $\sigma$ auch an den positiv geladenen Kontaktpunkten kleiner als 1 wird.

Die Erfindung ist selbstverständlich nicht auf die beschriebenen Ausführungsbeispiele beschränkt. So ist die Erfindung für alle Verfahren zum Testen von Leitungsnetzwerken (Leiterplatten, Verdrahtungsmodulen, Hybridschaltungen, SMD-Baugruppen usw.), anwendbar, bei denen eine in das Netzwerk eingebrachte Ladung während der gesamten Meßzeit gespeichert bleiben muß.

Die Erfindung bezieht sich auch auf die Erhaltung des ungeladenen Zustandes durch Kompensation der kapazitiven Aufladungseffekte sowie der durch Streuelektronen verursachten Potentialänderungen.

Es ist selbstverständlich auch nicht notwendig, die untersuchte Probe ganzflächig zu bestrahlen. Der Haltestrahl HS kann deren Oberfläche auch zeilenförmig überstreichen.

**Patentansprüche**

1. Verfahren zum Testen von Leitungsnetzwerken, bei dem der Ladungszustand eines ersten Punktes (1) des Leitungsnetzwerkes mittels eines ersten Teilchenstrahls (PE) verändert wird, bei dem der erste oder ein zweiter Teilchenstrahl (PE) auf einen zweiten Punkt (2) des Leitungsnetzwerkes gerichtet wird und bei dem der Ladungszustand des zweiten Punktes (2) durch Nachweis der an diesem zweiten Punkt (2) ausgelösten Sekundärteilchen abgetastet wird, dadurch **gekennzeichnet,** daß zumindest diese beiden Punkte (1,2) des Leitungsnetzwerkes mit einem weiteren Teilchenstrahl (HS) beaufschlagt werden, dessen Teilchenenergie ($E_{HS}$) so bemessen ist, daß ein im Leitungsnetzwerk auftretender Ladungsverlust kompensiert wird.

2. Verfahren nach Anspruch 1, dadurch **gekennzeichnet,** daß die Teilchenenergie ($E_{PE}$) des ersten Strahls (PE) so gewählt ist, daß sich die mit diesem Strahl (PE) beaufschlagten Punkte (1, 2) negativ aufladen und daß die Teilchenenergie ($E_{HS}$) des weiteren Strahls (HS) so gewählt ist, daß sich ein mit diesem Strahl (HS) beaufschlagter ungeladener Punkt positiv auflädt.

3. Verfahren nach Anspruch 1, dadurch **gekennzeichnet,** daß die Teilchenenergie ($E_{PE}$) des ersten Strahls (PE) so gewählt ist, daß sich die mit diesem Strahl (PE) beaufschlagten Punkte (1, 2) positiv aufladen und daß die Teilchenenergie ($E_{HS}$) des weiteren Strahls (HS) so gewählt ist, daß sich ein mit diesem Strahl (HS) beaufschlagter ungeladener Punkt negativ auflädt.

4. Verfahren nach einem der Ansprüche 1 bis 3, dadurch **gekennzeichnet,** daß der weitere Teilchenstrahl (HS) immer dann eingeschaltet ist, wenn der erste oder der zweite Teilchenstrahl (PE) ausgeschaltet ist.

5. Verfahren nach einem der Ansprüche 1 bis 4, dadurch **gekennzeichnet,** daß der Durchmesser des weiteren Teilchenstrahles (HS) auf dem Leitungsnetzwerk etwa den Abmessungen eines zu testenden Teilbereiches des Leitungsnetzwerkes entspricht.

6. Verfahren nach einem der Ansprüche 1 bis 5, dadurch **gekennzeichnet,** daß der weitere Teilchenstrahl (HS) zeilenförmig über das Leitungsnetzwerk abgelenkt wird.

**Claims**

1. Method for testing wire networks, in which method the state of charge of a first point (1) of the wire network is altered by means of a first particle beam (PE), in which the first or a second particle beam (PE) is directed to a second point (2) of the wire network, and in which the state of charge of the second point (2) is sampled by detection of the secondary particles released at this second point (2), characterised in that at least these two points (1, 2) of the wire network are acted upon by a further particle beam (HS), the particle energy ($E_{HS}$) of which is dimensioned so that a loss of charge occurring in the wire network is compensated.

2. Method according to Claim 1, characterised in that the particle energy ($E_{PE}$) of the first beam (PE) is selected so that the points (1, 2) acted upon by this beam (PE) become negatively charged, and in that the particle energy ($E_{HS}$) of the further beam (HS) is selected so that an uncharged point acted upon by this beam (HS) becomes positively charged.

3. Method according to Claim 1, characterised in that the particle energy ($E_{PE}$) of the first beam (PE) is selected so that the points (1, 2) acted upon by this beam (PE) become positively charged, and in that the particle energy ($E_{HS}$) of the further beam (HS) is selected so that an uncharged point acted upon by this beam (HS) becomes negatively charged.

4. Method according to one of Claims 1 to 3, characterised in that the further particle beam (HS) is always activated when the first or the second particle beam (PE) is deactivated.

5. Method according to one of Claims 1 to 4, characterised in that the diameter of the further particle beam (HS) on the wire network corresponds approximately to the dimensions of a partial region, to be tested, of the wire network.

6. Method according to one of Claims 1 to 5, characterised in that the further particle beam (HS) is deflected rectilinearly over the wire network.

**Revendications**

1. Procédé pour tester des réseaux de lignes, selon lequel on modifie l'état de charge d'un premier point (1) du réseau de lignes à l'aide d'un premier faisceau de particules (PE), et selon lequel on dirige le premier ou un second faisceau de particules (PE) sur un second point (2) du réseau de lignes, et on explore l'état de charge du second point (2) par détection des particules secondaires émises au niveau de ce second point (2), caractérisé par le fait qu'on charge au moins ces deux points (1,2) du réseau de lignes à l'aide d'un autre faisceau de particules (HS), dont l'énergie ($E_{HS}$) des particules est dimensionnée de manière qu'une perte de charge apparaissant dans le réseau de lignes est compensée.

2. Procédé suivant la revendication 1, caractérisé par le fait que l'énergie ($E_{PE}$) des particules du premier faisceau (PE) est choisie de manière que les points (1,2), qui reçoivent ce faisceau (PE), sont chargés négativement, et que l'énergie ($E_{HS}$) des particules de l'autre faisceau (HS) est choisie de manière qu'un point non chargé, qui reçoit ce faisceau (HS), se charge positivement.

3. Procédé suivant la revendication 1, caractérisé par le fait que l'énergie ($E_{PE}$) des particules du premier faisceau (PE) est choisie de manière que les points (1,2) recevant ce faisceau (PE) se chargent positivement et que l'énergie ($E_{PE_{HS}}$) des particules de l'autre faisceau (HS) est choisie de manière qu'un point non chargé, recevant ce faisceau (HS), se charge négativement.

4. Procédé suivant l'une des revendications 1 à 3, caractérisé par le fait que l'autre faisceau de particules (HS) est branché chaque fois que le premier faisceau de particules (PE) est éteint.

5. Procédé suivant l'une des revendications 1 à 4, caractérisé par le fait que le diamètre de l'autre faisceau de particules (HS) sur le réseau des lignes correspond approximativement aux dimensions d'une zone partielle à tester du réseau de lignes.

6. Procédé suivant l'une des revendications 1 à 5, caractérisé par le fait que l'autre faisceau de particules (HS) est dévié suivant des lignes sur le réseau de lignes.

# FIG 1

# FIG 2